# EUROPEAN PATENT APPLICATION

(11) **EP 4 506 985 A1**
(43) Date of publication of application: **12.02.2025**
(21) Application number: 23190577.9
(22) Date of filing: 09.08.2023
(51) Int. Cl.: H01L 21/673

(54) **CONTAINER FOR STORAGE AND/OR TRANSPORT OF A SUBSTRATE**

(71) Applicant: Brooks Automation (Germany) GmbH, 78256 Steißlingen (DE)
(72) Inventor: REBSTOCK, Lutz, 78343 Gaienhofen (DE)
(74) Representative: Dehns Germany Partnerschaft mbB

(57) **Abstract**

The present invention relates to a container (100) configured and adapted for storage and/or transport of a substrate, provided with a cylinder-piston-mechanism (200) comprising a piston (210) reciprocatingly movable within a cylinder (220), the cylinder-piston-mechanism being configured and adapted to secure a substrate within the container (100) by engaging the substrate with an engagement member (210b) attached to the piston (210).

## Description

The present invention relates to a container configured and adapted for storage and/or transport of a substrate, a system for substrate storage and/or inspection and /or processing, as well as a method for loading a substrate from a container into a load port of unit for storage and/or inspection and/or processing of a substrate.

The term substrate as used in this application is meant to comprise various substrates used in connection with semiconductor manufacturing. The description mainly refers to reticles, but the invention is also applicable for example to semiconductor wafers.

In photolithography for mass production of integrated circuits, lithographic photo masks are used. These are commonly known as photoreticles or simply reticles. A reticle is typically an optically clear quartz substrate, on which a pattern has been formed by photolithography or a similar process. Reticles are essentially used as illumination masks in connection with illumination of wafers during semiconductor manufacture.

In order to ensure an effective production of integrated circuits with as little rejects as possible, reticles must be kept as clean as possible during manufacture, storage, transport and processing, i.e. usage, for example in a scanner or stepper device. Especially, it is important to minimize airborne particle fluxes onto the surface of a reticle, as these will adversely influence the quality of integrated circuits produced.

During reticle production, which is often a multi step process, including for example illumination, etching, cleaning and inspection steps, it is common to store reticles in large storage units usually referred to a stockers. For transporting a reticle from a stocker to a production unit, an inspection unit or a stepper, in which the reticle is used for photolithography, it is common to use containers configured and adapted for storage of such reticles. These containers are usually referred to as pods.

In recent time, due to implementation of Extreme Ultraviolet Lithography techniques (EUV), which use extreme ultraviolet wavelengths of around 13.5 nm, the cleanliness requirements for storing and transporting reticles, as well as for the environment in which EUV lithography is performed, have increased dramatically. It is thus now desirable to store and transport reticles under vacuum conditions, so that for example airborne particle flux can be minimized.

Also, it is of great importance to ensure a safe transport of reticles within transport containers, i.e. pods. Movement, especially sliding movement, of reticles within containers during transport must be avoided, as this can lead to abrasion, which can contaminate a reticle, or to other forms of damage. In prior art containers, means for securing reticles within containers are relatively cumbersome to use, thereby complicating handling of reticles and containers.

The present invention seeks to simplify handling of reticles (and also of other semiconductor substrates) and their respective containers during storage and/or transport and/or usage.

According to a first aspect of the invention, there is provided a container configured and adapted for storage and/or transport of a substrate, such as a reticle, provided with a cylinder-piston-mechanism comprising a piston reciprocatingly (i.e. backwards and forwards) movable within a cylinder, the cylinder-piston-mechanism being configured and adapted to secure a substrate within the container by engaging the substrate with an engagement member attached to the piston. Such a cylinder-piston-mechanism significantly simplifies securing a reticle within a container.

Advantageously, the container is configured and adapted to be evacuated. Providing the cylinder-piston-mechanism in a container which can be evacuated is especially advantageous, as securing a substrate within such a container can be simplified as compared to previous solutions. For example, if a pressurization of the cylinder-piston-mechanism is configured taking into account various operating pressures the interior volume of the container is subjected to, a gentle and especially non-abrasive engagement of a reticle can be provided in an essentially automatic manner.

According to a preferred embodiment, a gas, such as Nitrogen, is provided within a variable cylinder-volume defined by the cylinder and the position of the piston within the cylinder, such that in a first pressure state, in which the pressure within the container is at a first pressure value, the variable volume corresponds to a first volume, and in a second state, in which the pressure within the container is at a second pressure value, which is lower than the first pressure value, the variable volume corresponds to a second value, which is larger than the first volume.

For example, the first pressure value is atmospheric pressure, which can typically occur during loading of the container with a reticle (i.e. during a phase during which the container is in an opened state in order to receive a reticle therein), and the second pressure value corresponds to a pressure provided after evacuation of the container, i.e. a substantially lower pressure than atmospheric pressure. Maintaining the container in an evacuated state during transport of the reticle is advantageous in connection with minimizing contamination, as outlined above. By setting a pressure within the variable cylinder volume for example at or slightly below atmospheric pressure for a first, relatively small volume, it can be ensured that, as long as the pressure within the container remains at atmospheric pressure, no movement of the piston within the cylinder will occur (as the pressure values within the container and the volume defined by the cylinder and the piston are equal or the pressure value within the cylinder volume is even slightly lower than in the container). In case the container is then evacuated, i.e. leading to a reduced pressure within the container, the pressure within the variable cylinder volume becomes larger than the pressure in the container, leading to an expansion of the variable volume, i.e. an outward movement of the piston within the cylinder. Hereby, the engagement member fixedly attached to the piston can be brought into engagement with a substrate to be the secured within to the container. Especially, by effecting the evacuation in a controlled manner, it can be ensured that the actual engagement of the substrate, especially the reticle, is effected in a gentle manner, thereby minimizing danger and occurance of abrasive effects to the substrate or damaging the substrate.

Advantageously, the container is provided with a base member configured and adapted to receive a substrate thereon, wherein the cylinder-piston-mechanism is configured and adapted to secure the substrate on the base member. A container will typically further comprise a shell member, which is sealingly, i.e. in an airtight manner, engageable with the base member to form an interior volume of the container, which can be evacuated. The cylinder of the cylinder-piston-mechanism is, for example, fixedly attached to such a shell member.

As mentioned, the container is especially advantageous for the storage and/or transport of a reticle. Be it again noted, however, that a container according to the invention is equally useful for other substrates, such as semiconductor wafers etc, especially other substrates as used in EUV applications.

According to a further aspect, the invention suggests a system for substrate storage and/or inspection and/or processing, comprising a unit for storage and/or inspection and/or processing of a substrate provided with a load port defining a load port volume, in which substrates are to be received, and a container configured and adapted for storage and/or transport of a substrate, especially a container as described above, the load port further comprising a docking mechanism for docking a container containing a substrate thereto, the docking mechanism being configured and adapted to open the container and transport the reticle into the load port volume. The term processing as used in the present specification is to be understood as covering manufacture as well as actual usage. Thus, in case of reticles, it covers the manufacture of reticles as well as their actual usage in connection with illumination of wafers, for example.

This system is especially advantageous if the load port volume is an evacuated volume, and the container is an evacuated container.

Advantageously, the evacuated container comprises a base member configured and adapted to receive a substrate thereon and a cylinder-piston-mechanism configured and adapted to secure the substrate on the base member, wherein the docking mechanism is configured and adapted to transport the base member and the substrate received thereon into the evacuated load port volume, thereby terminating the securing of the substrate on the base member by means of the cylinder-piston-mechanism. By transporting the base member into the load port volume and thus away from the cylinder-piston mechanism, which is advantageously provided on the shell in a manner fixedly attached to the shell member of the container, the reticle is automatically disengaged from the engagement member of the cylinder-piston-mechanism, and can subsequently be processed further, for example gripped by a gripping member provided in the load port, in a simple manner.

Expediently, a gripping member provided in the load port volume to remove the substrate from the base member, the docking mechanism being further adapted to transport the base member of the container (now typically without the substrate, which has been removed from it by the gripping member) out of the load port volume and to close the evacuated container, thereby repositioning the base member on the evacuated container, especially on the shell member of the container..

According to a further aspect, the invention also suggests a method for loading a substrate from a container configured and adapted for storage and/or transport of a substrate, especially a container as described above, , into a load port of a unit for storage and/or inspection and/or processing of a substrate, the load port being provided with a load port volume, in which substrates are to be received, comprising the following steps:-
- docking the container to the load port
- opening the container and transporting the substrate from the container into the load port volume.

According to an advantageous embodiment of the method, the load port volume is an evacuated volume and the container is an evacuated container, as outlined above.

Preferred embodiments of the invention will now be described referring to the accompanying figures. Herein:
Figure 1 shows a schematic side sectional view of a first embodiment of a container according to the invention in a first stage of operation,
Figure 2 the embodiment of figure 1 in a second stage of operation,
Figures 3 to 5 show a preferred embodiment of the system according to the invention in various different stages of operation.

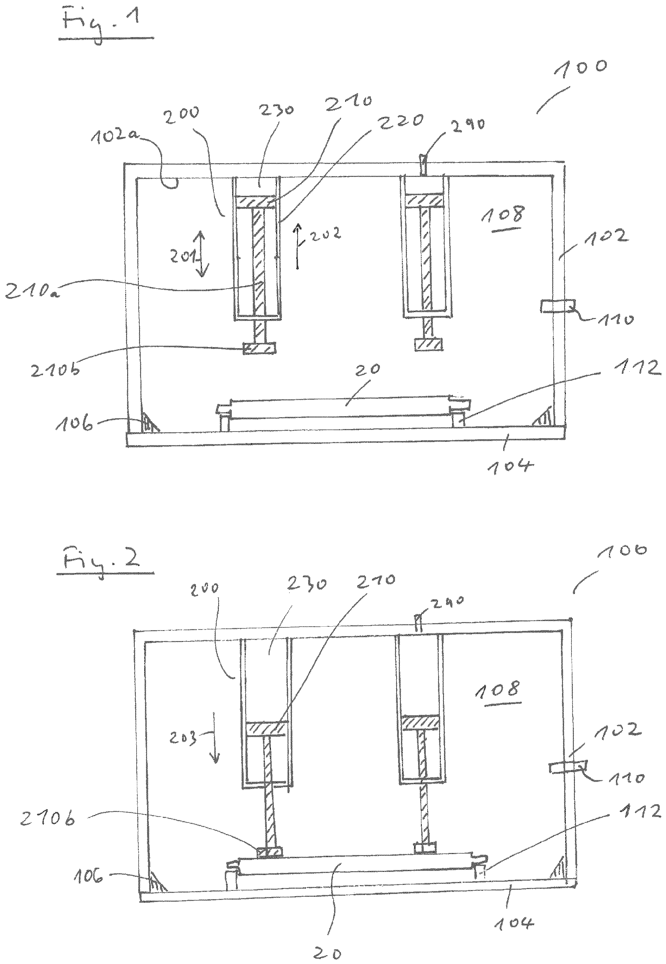

Referring to Figures 1 and 2, a preferred embodiment of a container according to the present invention is generally designated 100. It comprises a shell member 102 and a base member 104. By means of a sealing mechanism 106 (schematically shown), an airtight engagement between shell 102 and base member104 can be provided. In order to be able to evacuate the interior volume 108 of container 100, a vacuum valve 110 is provided. This vacuum valve 110 can be connected to evacuation means (not shown).

On the inside of base member 104 there is provided a receiving component 112, which is adapted to receive a reticle 20 thereon.

The container 100 is also provided with a plurality of cylinder-piston-mechanisms 200. Typically, in order to be able to engage a usually square shaped reticle at its four corners, four such cylinder-piston-mechanisms can be provided. Other numbers are also possible, in Figures 1 and 2, two cylinder-piston mechanisms are shown.

In the example shown, the cylinder-piston-mechanisms 200 comprise a piston 210 moveable in a reciprocating manner (indicated by arrow 201) within a cylinder 220. In the embodiment shown in Figure 1, the cylinders are fixedly attached to an inner surface 102a of shell 102. Cylinder 220 and piston 210 define a variable volume 230. By means of the piston 210 sealingly engaging inner wall of cylinder 220, this volume is sealed against the interior volume 108 of container 100 in an airtight manner.

Each piston is attached to a piston rod 210, at the end of which there is provided an engagement member 210b.

Variable volume 230 is filled with a working gas such as Nitrogen. In Figure 1, piston 210 is in a position defining a relatively small volume 230. Be it assumed that in this piston position the pressure within volume 230 equals or is slightly lower (for example 50-100 mbar) than atmospheric pressure. Be it also assumed that the pressure in the interior volume 108 of container 100 is atmospheric pressure.

As, under these conditions, the forces acting of piston 210 are either zero or directed upwards (as indicated by arrow 202), piston 210 will remain in its position shown in Figure 1.

If interior volume 108 is now evacuated, for example by connecting evacuating means to vacuum valve 110, the pressure within interior volume 108 will gradually decrease. As soon as it becomes lower than the pressure within volume 230, a net force will act on pistons 210 in a downward direction, as indicated by arrow 203 in Figure 2. Thus, piston 210 together with piston rod 210a and engagement member 210b will be displaced in the downward direction indicated by arrow 203, until engagement member comes into engagement with reticle 20 on receiving component 112. By controlling the speed of evacuation, especially during the time the engagement member 210b comes into engagement with reticle 20, reticle 20 can be reliably and safely, and at the same time gently, secured on the receiving component. Hereby, danger of damaging the reticle can be minimized. Also, by expediently choosing an initial pressurization of the variable cylinder volume 230, the final force, with which engagement member 210b engages reticle 20, can be set. It is also possible to vary the pressure, i.e. especially the initial pressurization within cylinder volume 230, for example using a pressure valve 290 (shown schematically for one of the cylinder-piston mechanisms 200) connected to a gas reservoir (not shown). Hereby also, the movement of the piston can be controlled. Especially in connection with non-evacuated containers, it is thus possible to control the pistons in a desired manner. For example, after loading the container with a reticle, the container can be closed (without being evacuated), and be pressurization of variable volumes 230 the pistons 210 can be controlled in order to bring engagement members 210b into engagement with the reticle. After securing the reticle in this way, valves 290 can be closed to maintain the pressure in volumes 230 for example during transport of the container.

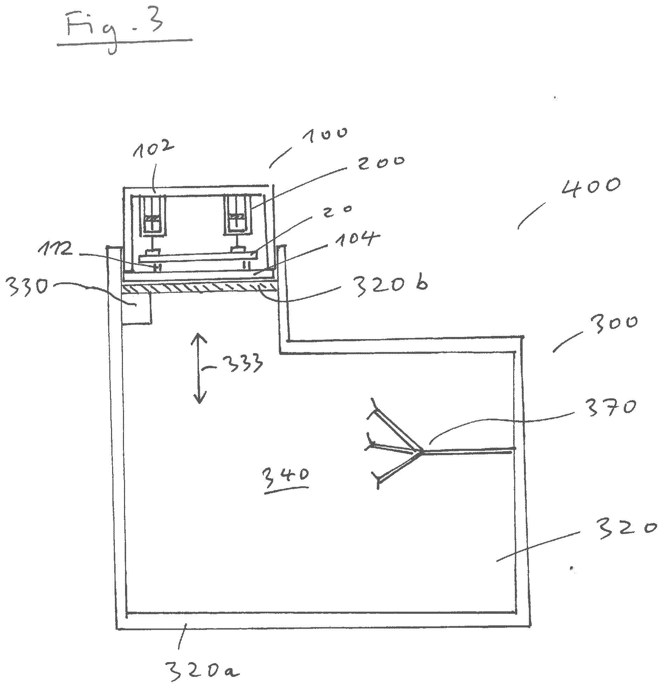

Referring now to Figures 3-6, a preferred embodiment of the system and the method according to the invention will be explained.

The system shown in various states of operation in Figures 3-5 is generally designated 400. It comprises a container 100 and a unit 300 for storing and/or inspecting and/or processing a reticle. Unit 300, of which only a load port 320 is shown in the Figures, can for example be a stepper, in which wafers are illuminated using reticles provided via load port 320 under EUV lithography conditions.

Figure 3 depicts the situation in which an evacuated container 100, in which a reticle 20 is secured by means of cylinder-piston-mechanisms as described above, is docked to a schematically shown docking mechanism 330 of load port 320.

Load port 320 comprises a fixed walling 320a and a displaceable wall member 320b, which is reciprocatingly displaceable relative to walling 320a in the direction indicated by double arrow 333. Walling 320a and wall member 320b are in sealing engagement with one another, thus providing an evacuated load port volume 340. Means, by which evacuation of load port volume 340 is achieved, are not shown in the Figures.

Docking mechanism 330 is configured and adapted to engage and open container 100, at the same time maintaining evacuated conditions within the container (volume 108) and the load port (load port volume 340).

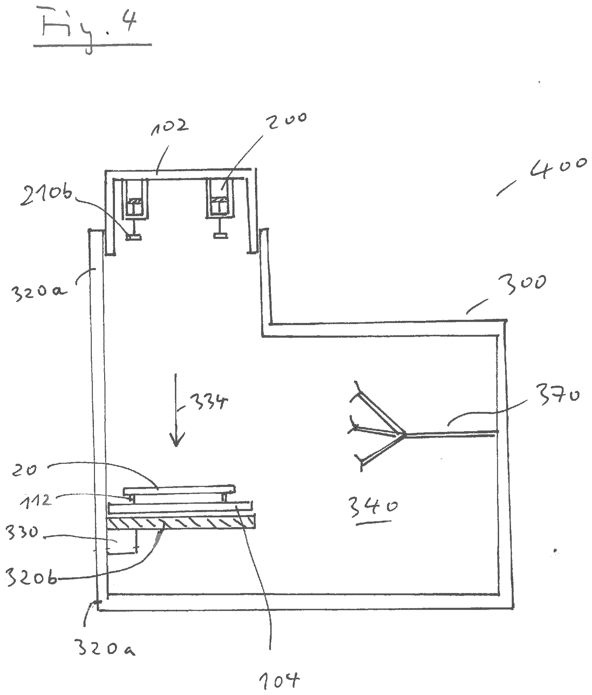

This is achieved by bringing wall member 320b into engagement with base member 104, and disengaging base member 104 from shell member 102. Herein, the container 100 and load port 320 are kept in sealing engagement relative to the environment. i.e. in other words the evacuated volumes 108 and 340 are combined. In this state, the vacuum is ensured by an airtight sealing engagement of walling 320 with shell member 102, as best seen in Figure 4.

After disengagement of base member 104 from shell member 102, docking mechanism 330 transports wall member 320b with base member 104 engaged thereto in downward direction, as indicated by arrow 334 in Figure 4., for example by means of guide rails (not shown). Hereby, reticle 20, which is received on receiving member 112 of base member 104, comes out of engagement with engagement members 210 b. This means, that by lowering the base member into load port 320, the securing of reticle 20 by means of the cylinder-piston mechanisms 200 is terminated.

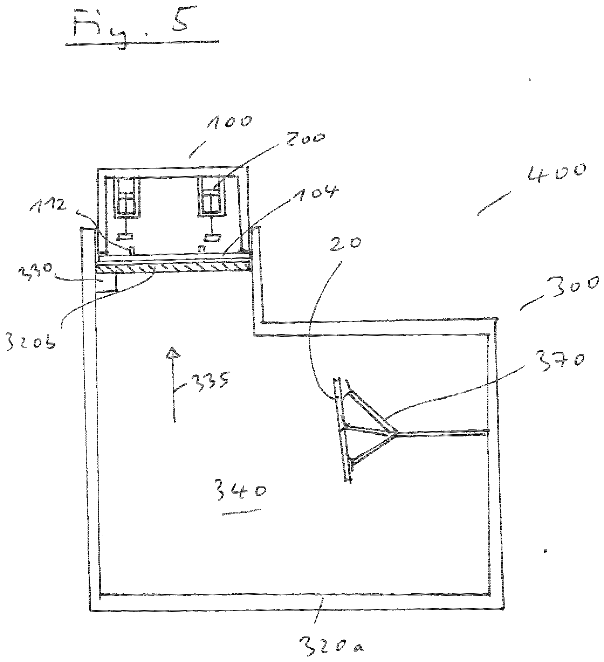

The reticle can now be easily gripped by gripper mechanism 370, and wall member 320b, which is still in engagement with base member 104, can be raised in direction of arrow 335, as shown in Figure 5.

Wall member is raised to the position in which base member 104 of container 100 again engages shell member 102. In this position, base member can be disengaged from wall member 320b, again by means of docking mechanism 330, and shell member 102 and base member 104 brought into airtight engagement. Hereby, the two evacuated volumes 108 and 340 are separated again.

The container can now be removed from the load port 320 of unit 300, maintaining the evacuated conditions within container 100 as well as in load port 320.

## Claims

1. Container (100) configured and adapted for storage and/or transport of a substrate, provided with a cylinder-piston-mechanism (200) comprising a piston (210) reciprocatingly movable within a cylinder (220), the cylinder-piston-mechanism being configured and adapted to secure a substrate within the container (100) by engaging the substrate with an engagement member (210b) attached to the piston (210).

2. Container according to claim 1, configured and adapted to be evacuated.

3. Container according to claim 1 or 2, wherein a gas is provided within a variable cylinder volume (230) defined by the cylinder (220) and a position of the piston (210) within the cylinder (220), such that in a first pressure state, in which the pressure within the container (100) is at a first pressure value, the variable volume corresponds to a first volume, and in a second state, in which the pressure within the container (100) is at a second pressure value, which is lower than the first pressure value, the variable volume corresponds to a second value, which is larger than the first volume.

4. Container according to claim 3, wherein the first pressure value is atmospheric pressure and the second pressure value is a pressure provided during or after evacuation of the container.

5. Container according to any one of the preceding claims, provided with a base member (110) configured and adapted to receive a substrate thereon, the cylinder-piston-mechanism (200) being configured and adapted to secure the substrate on the base member (110).

6. Container according to any one of the preceding claims, configured and adapted for storage and/or transport of a reticle.

7. System for substrate storage and/or inspection and/or processing, comprising a unit for storage and/or inspection and/or processing of a substrate provided with a load port defining a load port volume(340), in which substrates are to be received, and a container configured and adapted for storage and/or transport of a substrate, especially a container according to any one of the preceding claims, the load port further comprising a docking mechanism (330) for docking a container (100) containing a substrate thereto, the docking mechanism(330) being configured and adapted to open the container (100) and transport the reticle into the load port volume (340).

8. System according to claim 7, wherein the load port volume (340) is an evacuated volume, and the container (100) is an evacuated container.

9. System according to claim 8, wherein the evacuated container comprises a base member (110) configured and adapted to receive a substrate thereon and a cylinder-piston-mechanism (200) being configured and adapted to secure the substrate on the base member (110), wherein the docking mechanism (330) is configured and adapted to transport the base member (104) and the substrate received thereon into the evacuated load port volume (340), thereby terminating the securing of the substrate on the base member by means of the cylinder-piston-mechanism.

10. System according to claim 8 or 9, comprising a gripping member (370) providing in the load port volume configured and adapted to remove the substrate from the base member, the docking mechanism being further adapted to transport the base member of the container out of the load port volume and to close the evacuated container, thereby repositioning the base member on or within the evacuated container.

11. Method for loading a substrate from a container configured and adapted for storage and/or transport of a substrate, especially a container according to any one of claims 1-6, into a load port of a unit for storage and/or inspection and/or processing of a substrate, the load port being provided with a load port volume, in which substrates are to be received, comprising the following steps:-
- docking the container to the load port
- opening the container and transporting the substrate from the container into the load port volume.

12. Method according to claim 11, wherein the load port volume is an evacuated volume and the container is an evacuated container.

## Amended claims

### Amended claims in accordance with Rule 137(2) EPC.

1. Container (100) configured and adapted for storage and/or transport of a substrate, **characterized in that** it is provided with a cylinder-piston-mechanism (200) comprising a piston (210) reciprocatingly movable within a cylinder (220), the cylinder-piston-mechanism being configured and adapted to secure a substrate within the container (100) by engaging the substrate with an engagement member (210b) attached to the piston (210).

2. Container according to claim 1, configured and adapted to be evacuated.

3. Container according to claim 1 or 2, wherein a gas is provided within a variable cylinder volume (230) defined by the cylinder (220) and a position of the piston (210) within the cylinder (220), such that in a first pressure state, in which the pressure within the container (100) is at a first pressure value, the variable volume corresponds to a first volume, and in a second state, in which the pressure within the container (100) is at a second pressure value, which is lower than the first pressure value, the variable volume corresponds to a second value, which is larger than the first volume.

4. Container according to claim 3, wherein the first pressure value is atmospheric pressure and the second pressure value is a pressure provided during or after evacuation of the container.

5. Container according to any one of the preceding claims, provided with a base member (110) configured and adapted to receive a substrate thereon, the cylinder-piston-mechanism (200) being configured and adapted to secure the substrate on the base member (110).

6. Container according to any one of the preceding claims, configured and adapted for storage and/or transport of a reticle.

7. System for substrate storage and/or inspection and/or processing, comprising a unit for storage and/or inspection and/or processing of a substrate provided with a load port defining a load port volume(340), in which substrates are to be received, and a container configured and adapted for storage and/or transport of a substrate according to any one of the preceding claims, the load port further comprising a docking mechanism (330) for docking a container (100) containing a substrate thereto, the docking mechanism(330) being configured and adapted to open the container (100) and transport the reticle into the load port volume (340).

8. System according to claim 7, wherein the load port volume (340) is an evacuated volume, and the container (100) is an evacuated container.

9. System according to claim 8, wherein the evacuated container comprises a base member (110) configured and adapted to receive a substrate thereon and a cylinder-piston-mechanism (200) being configured and adapted to secure the substrate on the base member (110), wherein the docking mechanism (330) is configured and adapted to transport the base member (104) and the substrate received thereon into the evacuated load port volume (340), thereby terminating the securing of the substrate on the base member by means of the cylinder-piston-mechanism.

10. System according to claim 8 or 9, comprising a gripping member (370) providing in the load port volume configured and adapted to remove the substrate from the base member, the docking mechanism being further adapted to transport the base member of the container out of the load port volume and to close the evacuated container, thereby repositioning the base member on or within the evacuated container.

11. Method for loading a substrate from a container configured and adapted for storage and/or transport of a substrate according to any one of claims 1-6, into a load port of a unit for storage and/or inspection and/or processing of a substrate, the load port being provided with a load port volume, in which substrates are to be received, comprising the following steps:-
- docking the container to the load port
- opening the container and transporting the substrate from the container into the load port volume.

12. Method according to claim 11, wherein the load port volume is an evacuated volume and the container is an evacuated container.
